# DEMANDE DE BREVET EUROPEEN

(11) **EP 0 527 060 A1**
(43) Date de publication de la demande: **10.02.1993**
(21) Numéro de dépôt: 92401354.3
(22) Date de dépôt: 19.05.1992
(51) Int. Cl.: H01L 31/173, H01L 33/00

(54) **Emetteur-récepteur optique à semiconducteurs**

(30) Priorité: 07.06.1991 FR 9106933
(71) Demandeur: THOMSON-CSF, 75008 Paris (FR)
(72) Inventeur: Blondeau, Robert, F-92045 Paris la Défense (FR); Rondi, Daniel, F-92045 Paris la Défense (FR); Renaud, Jean-Charles, F-92045 Paris la Défense (FR)
(74) Mandataire: Guérin, Michel

(57) **Abrégé**

L'invention concerne un dispositif optoélectronique intégrant monolithiquement un émetteur laser (L) un détecteur optique (DEC) placés en ligne sur un même guide d'onde et fonctionnant à des longueurs d'ondes différentes.

APPLICATIONS : Transmissions optiques - Télécommunications

## Description

L'invention concerne un émetteur-récepteur optique à semiconducteurs et plus particulièrement un émetteur et un récepteur de lumière intégrés sur un même substrat et couplés à un même guide optique.

Plus précisément, l'invention concerne un dispositif optoélectronique intégrant monolithiquement un laser à semiconducteur Perot-Fabry ou à réflecteur à réseau distribué (rétroaction distribuée DFB) et un photodétecteur, chacun fonctionnant à une longueur d'onde particulière et placés tous deux en ligne sur un même guide d'onde. L'émission et la détection pourront se faire de façon simultanée avec une possibilité de fonctionnement en détecteur alternativement avec l'émission du laser.

En raison des avantages qu'offre la transmission optique (capacité, encombrement, insensibilité aux perturbations, etc ...), le raccordement d'usagers par fibres optiques à divers réseaux, tels les réseaux de vidéo distribution ou les réseaux numériques à intégration de services (RNIS), présente un intérêt de plus en plus grand. De plus, la transmission bidirectionnelle sur la même fibre devrait permettre la réduction du coût du support par usager.

Cependant, il est nécessaire de disposer de composants d'extrémités tels que des dispositifs émetteur/récepteur ayant un coût de fabrication le plus faible possible. Cela implique la mise au point de structures nouvelles intégrant de façon monolithique les deux fonctions d'émission et de réception avec entrée et sortie commune sur la même fibre.

On connaît dans la technique différentes solutions réalisées soit en intégration monolithique, soit par hybridation des deux fonctions d'émission et de réception.

C'est ainsi que le document B. HILLERICH et al "Transceiver module for single mode fiber subscriber link", IOOC'89, Kobé, vol. 2, pp. 76-77 décrit un duplexeur à deux longueurs d'onde pour liaisons bidirectionnelles réalisé en technologie hybride.

Le document K. YAMAGUHI et al, EOOC' 87, pages 275-278 décrit un duplexeur associant une diode électroluminescente et un photodétecteur en technologie hybride.

Le document V. KOREN et al, IOOC'89, KOBE, vol. 2, page 8-9 décrit la réalisation de trois lasers DFB ajustables en longueurs d'ondes indépendamment, couplés grâce à un mélangeur dans un amplificateur optique de sortie, le tout intégré monolithiquement.

Des liaisons optiques bidirectionnelles et en particulier des composants émetteurs/récepteurs de type diodes électroluminescences ont été décrites dans les Brevets français numéros 2 273371, 2 406896, 2 426295, 2 493047 Cependant, ces types de composants assurent les fonctions émission et détection en alternatance et non simultanément.

Concernant l'intégration monolithique de plusieurs fonctions, différents dispositifs ont été réalisés.

Par exemple l'intégration d'un laser à rétroaction distribuée (DFB) et d'un guide faible pertes a été décrite dans le brevet français n° 2 596 529 et dans le document JC. RENAUD, R. RONDI, Y. BOURBIN, A. TALNEAU, G. GLASTRE, G. VILAIN, A. ENARD, R. BLONDEAU "Intégration monolithique d'un laser DFB 1,55 µm et d'un guide d'onde par épitaxies MOCVD" 3èmes Journées Nationales Microélectroniques et Optoélectroniques III-V, Mars 1990, ainsi que l'intégration d'un démultiplexeur avec ses guides d'accès décrite dans Interim Report ESPRIT 263, Period 09, Section A "Monolithic integration of a multi/demultiplexer and its access waveguides" ou l'intégration d'un amplificateur optique avec des guides passifs décrites dans la demande de brevet français n° 89 17087.

Enfin, le document T.L. KOCH et al, "Simple In-Line Bi-Directional 1,5 µm/1,3 µm Transceivers" - 12 th IEEE International Semiconductor laser conference, Sept. 9-14, 1990 DAVOS, Switzerland, décrit un laser et un détecteur à semiconducteurs alignés et réalisés sur un même substrat.

Cependant les structures décrites présentent des difficultés de réalisation et l'invention concerne une structure qui permet de résoudre ces difficultés.

L'invention concerne donc un émetteur-récepteur optique à semiconducteur comportant un détecteur et un laser couplés à un même guide d'onde caractérisé en ce que ce guide d'onde comporte un couche de guidage recouverte d'une couche d'arrêt d'attaque chimique sur laquelle est situé Lu élément de guidage.

L'invention concerne également un procédé de réalisation d'un émetteur-récepteur à semiconducteur caractérisé en ce qu'il comporte les étapes suivantes :
- épitaxie sur une face d'un substrat
   . d'une première couche de guidage optique,
   . d'une première couche d'arrêt d'attaque chimique,
   . d'une deuxième couche de guide optique,
   . de couches de matériaux nécessaires à la réalisation d'une part d'un laser et d'autre part, d'un photodétecteur,
- gravure du laser et du photodétecteur jusqu'à la deuxième couche de guidage optique ;
- gravure dans la deuxième couche de guidage optique d'un élément de guidage jusqu'à la première couche d'arrêt d'attaque chimique ;
- épitaxie d'une couche d'un matériau de confinement ;
- réalisation de jonctions PN, dans la couche de matériau de confinement.

Les différents objets et caractéristiques de l'invention apparaîtront plus clairement dans la description qui va suivre faite à titre d'exemple et dans les figures qui représentent :
- les figures 1 et 2, un exemple de réalisation générale selon l'invention ;
- les figures 3, 4 et 5 trois exemples de réalisations détaillés du dispositif selon l'invention ;
- les figures 6, 7 et 8 trois exemples de réalisations du procédé selon l'invention.

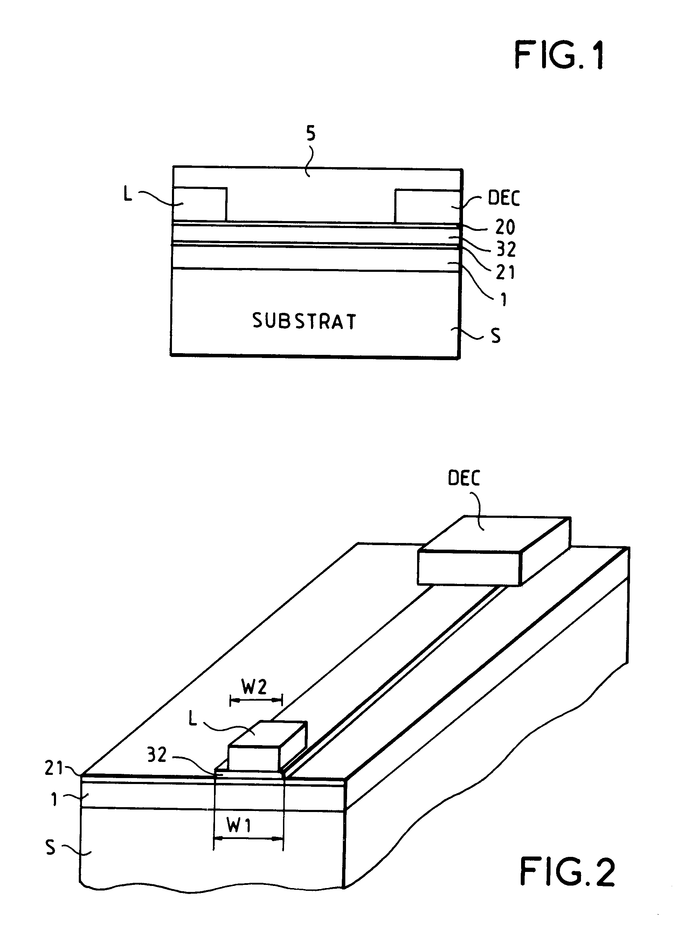

En se reportant aux figures 1 et 2, on va donc tout d'abord décrire un exemple de réalisation simplifié du dispositif de l'invention.

Ce dispositif comporte, sur un substrat S, une couche de guidage 1 recouverte par une couche d'arrêt d'attaque chimique 21 sur laquelle est située un élément de guidage 32. Le détecteur DEC et le laser L sont tous deux situés sur l'élément de guidage 2.

On peut également prévoir sur l'élément de guidage 2 une autre couche d'arrêt d'attaque chimique 20. L'ensemble est recouvert par une couche d'un matériau de confinement 5.

Comme on peut le voir sur la figure 2, la couche 1 et la couche 10 peuvent recouvrir une face du substrat S. Par contre, l'élément de guidage 32 a une largeur limitée W1.

Le laser L a de préférence une largeur W2 inférieure à la largeur W1. Le détecteur a une largeur de préférence égale ou supérieure à W1.

Pour concrétiser plus précisément l'idée de base de ce dispositif nous proposons de décrire trois versions de structures pouvant mener à sa réalisation ainsi que trois exemples concrets de réalisation.

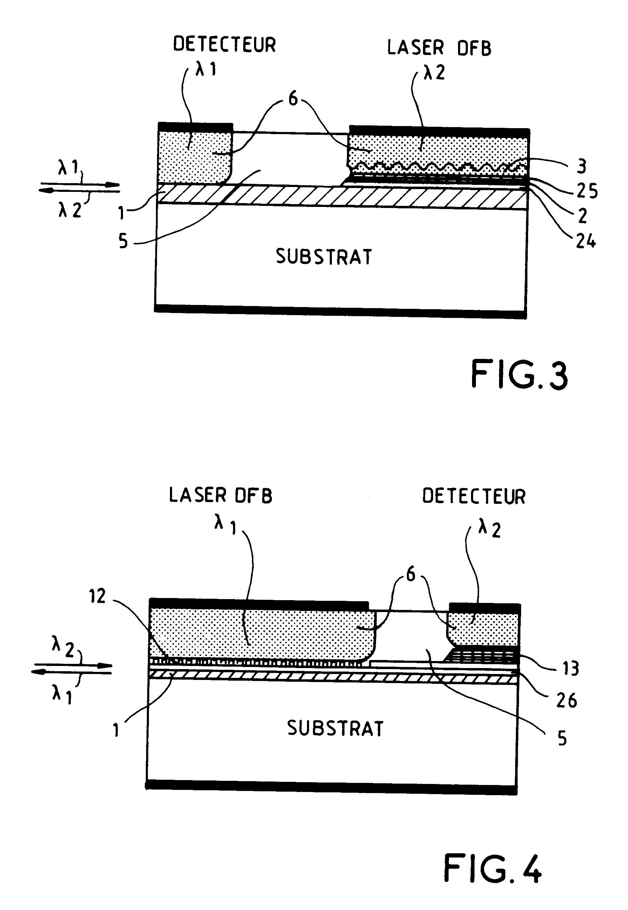

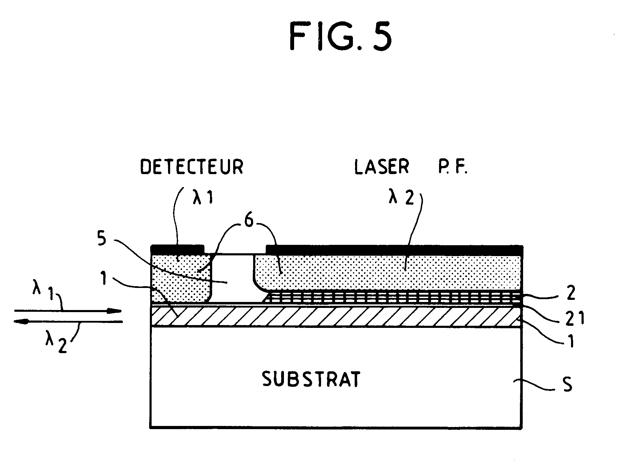

Les deux premières versions (figures 3 et 4) décrivent le principe d'intégration d'un laser à rétroaction distribuée (DFB) avec un photodétecteur. La troisième version (figure 5) concerne l'intégration d'un laser à cavité Perot-Fabry avec un photodétecteur, ce qui peut être intéressant pour le coût de fabrication.

En se reportant à la figure 3, on va donc maintenant décrire un exemple de réalisation de l'invention dans lequel le laser possède une cavité du type à rétroaction distribuée. Le dispositif de la figure 3 est tel qu'il émet à une longueur d'onde λ ₂ supérieure à la longueur d'onde détectée λ₁. La structure comporte essentiellement la couche 1 servant à la fois de couche absorbante (donc détectrice) à la longueur d'onde λ ₁ et de couche transparente (et guidante) à la longueur d'onde λ₂. Le gap du matériau constituant cette couche, Eg_{q1}, est tel que h 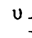 ₁> Eg_{q1} > h 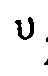 ₂.

Le laser DFB comporte un guide formé par la couche de l'élément actif 2 constituée soit d'un matériau massif, soit d'un ensemble de puits quantiques correspondant à la longueur d'onde d'émission λ₂, d'une couche transparente 3 à λ₂ et dans laquelle sera réalisé le réseau de diffraction pour la rétroaction distribuée. Comme décrit précédemment, une couche d'arrêt d'attaque chimique 24 est située entre la couche 1 et l'élément 2. Comme cela sera décrit ultérieurement la couche 24 permet de délimiter l'élément 2 et donc elle sert à la délimitation d'une structure guidante transverse pour le laser. Selon l'invention, on peut également prévoir entre la couche 3 et la couche 2, une couche d'arrêt d'attaque chimique 25 qui permettra de réaliser aisément le réseau de diffraction DFB dans la couche 3.

L'ensemble de ces couches est enterré par une reprise d'épitaxie 5 de matériau dont le gap est plus grand que celui du matériau constituant les couches guidantes 1 et 3 (par exemple de 1′ InP dans notre application). Les jonctions 6 de type P-N nécessaires à la réalisation du laser et du détecteur sont formées soit par diffusion soit par épitaxie localisée ou toutes autres méthodes.

Dans cette version, la fibre sera placée du côté du détecteur λ₁.

La figure 4 représente un autre exemple de réalisation du dispositif selon l'invention dans laquelle le laser comporte également une cavité à rétroaction distribuée.

Ce dispositif est complémentaire du dispositif de la figure 3. Il correspond au dispositif nécessaire à l'autre extrémité d'une fibre (par rapport au précédent), émettant à une longueur d'onde λ₁ et détectant à λ₂. La structure de ce dispositif comporte une couche 1 adaptée à la longueur d'onde d'émission λ₁ et transparente à la longueur d'onde détectée λ₂. Une couche 12 en matériau transparent à λ₁ et λ₂ servira à la réalisation du réseau de diffraction dans la section DFB émettant à λ₁. Cette couche 12 pourra être de même composition que la couche 1.

Une couche 13 en matériau absorbant à λ₂ constituera la zone détectrice du récepteur. La longueur de la partie guidante située entre le laser DFB et le détecteur sera suffisamment grande pour absorber toute la lumière provenant du laser DFB et éviter ainsi une diaphonie importante. Entre la couche 1 et l'élément 12 se trouve une couche d'arrêt d'attaque chimique 26. Comme dans le cas précédent, après délimitation d'une structure guidante transverse, une reprise d'épitaxie en matériau 5 ayant une largeur de bande interdite supérieure à celui des couches 1, 12 et 13 est effectuée pour enterrer toute la structure. Les jonctions P-N 6 nécessaires à la réalisation du laser et du détecteur sont formées par diffusion ou par épitaxie localisée ou autres.

La fibre optique sera placée du côté du laser émettant à λ₁.

La figure 5 représente un autre mode de réalisation dans lequel le laser est un laser Perot-Fabry émettant à une longueur d'onde λ₂ et le récepteur détecte une longueur d'onde λ ₁ avec λ₂ > λ₁.

La structure comprend une couche 1 en matériau absorbant à λ₁ et transparent à λ₂, une couche 2 adaptée à la longueur d'onde d'émission λ₂ et constituant la zone de gain du laser.

Comme précédemment, une couche d'arrêt d'attaque chimique 21 est située sur la couche 1 pour la gravure de la couche 2. De plus une structure guidante transverse est réalisée dans les couches 1, 21, 2 puis une reprise d'épitaxie 5 est effectuée pour enterrer la structure. Les jonctions P-N 6 du détecteur et du laser seront réalisées soit par diffusion, soit par épitaxie localisée ou autres. Le laser Perot-Fabry sera constitué par la cavité formée par les deux faces clivées d'extrémités, incluant les parties détectrice et guidante qui se trouvent être transparentes à la longueur d'onde d'émission λ₂. Dans cette version, la fibre sera placée côté détecteur λ₁. Cette structure limitée à un seul des deux composants nécessaires dans une liaison bidirectionnelle est intéressant de par sa simplicité pour l'obtention de composants à faibles coûts de fabrication.

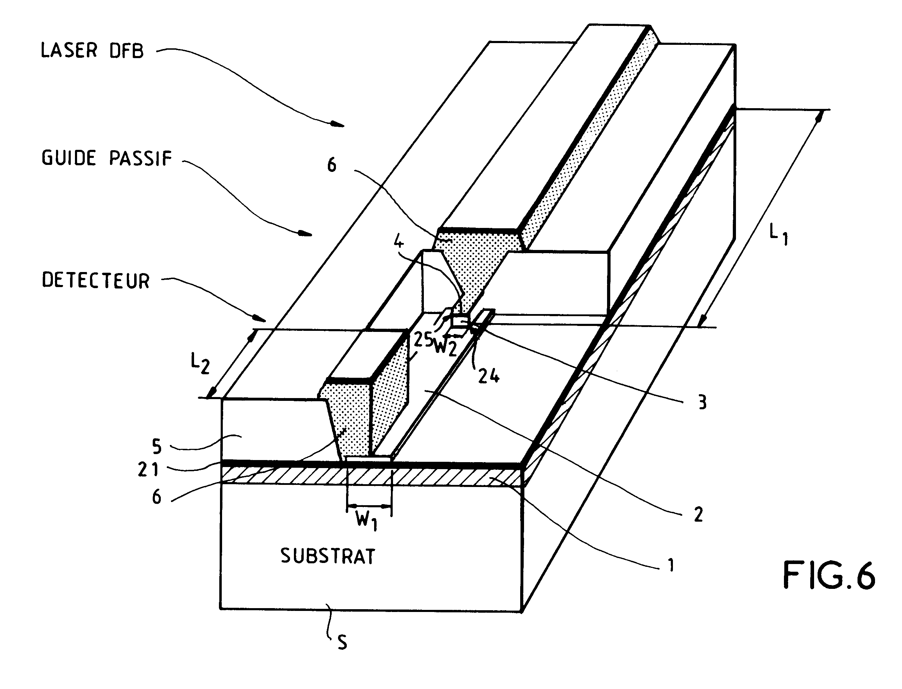

En se reportant à la figure 6, on va maintenant décrite un exemple de procédé de réalisation selon l'invention.

Ce procédé concerne la réalisation concrète du dispositif de la figure 3 intégrant un laser DFB λ₂ et un détecteur λ₁ de type "ruban" enterré. Dans cet exemple, la réalisation des jonctions P-N est effectuée par une reprise d'épitaxie localisée au dessus des rubans actifs (détecteur et émetteur) mais peut être aussi faite par diffusion localisée, ce qui réduit le nombre d'épitaxies.

Le processus technologique de réalisation est le suivant :
- une première épitaxie sur un substrat S semiconducteur comprenant au moins :
   . une couche guidante 1 en matériau transparent à la longueur d'onde λ₂ et absorbante à la longueur d'onde λ₁ (par exemple, du quaternaire adapté à λ1,35 µm pour λ ₁ = 1,3 µm et λ ₂ = 1,55 µm) ;
   . une première couche d'arrêt d'attaque chimique 21, par exemple en matériau binaire tel que de l'InP ;
   . une deuxième couche guidante 2 servant à délimiter latéralement le guide d'onde passif après sa gravure sous forme de ruban et dont l'épaisseur peut être de quelques dizaines de nanomètres. Le matériau constituant cette couche doit aussi être transparent à la longueur d'onde λ₂ (par exemple GaInAsP adapté à λ1,35 µm) ;
   . une couche 3 constituée d'un matériau ou de puits quantiques multiples adaptés à la longueur d'onde d'émission λ₂ (par exemple 1,55 µm). Cette couche peut être séparée de la couche 2 par une couche d'arrêt chimique 24 ;
   . une couche 4 servant à la réalisation du réseau de diffraction et transparent à λ₂ (par exemple du quaternaire 1,15 µm ou 1,3 µm ). La couche 4 peut également être séparée de la couche 3 par une couche d'arrêt d'attaque chimique 25.
- Après réalisation dans la couche 3 d'un réseau de diffraction adaptée à λ₂, une délimitation du ruban actif du laser DFB est effectuée par gravure chimique (ou autres méthodes, par exemple gravure ionique, RIE, etc ... ) à travers les couches 2 et 3 et 25 sur une longueur L₁ et une largeur W₂ et cela jusqu'à la couche 24. Le ruban servant de guide passif est ensuite réalisé par gravure à travers la couche 32 sur toute la longueur du composant et sur une largeur W₁ par les mêmes méthodes de gravure que précédemment jusqu'à la couche 21.
- Une deuxième épitaxie constituée d'une couche 5 en matériau de même nature que le substrat (par exemple InP), et si possible de type semi-isolant de manière à assurer une bonne isolation électrique entre le détecteur et l'émetteur, est effectuée sur toute la structure.
- Pour réaliser une hétérojonction P-N sur les rubans du détecteur et du laser plusieurs alternatives peuvent s'offrir. Citons deux cas par exemple :
   **1ER CAS** : diffusion localisée 6 d'une espèce dopante (par exemple du Zn pour le type P) effectuée à travers un masque de silice jusqu'aux couches détectrices 2 et laser 13.
   **2EME CAS** : après gravure d'un sillon dans la couche 5 localisé uniquement sur les zones détectrices et émettrice, réalisation par épitaxie d'une couche 6 dopée (par exemple Zn de type P) puis gravure de cette couche sous forme de ruban (voir figure 6) pour localiser la prise de contact.

Concernant les dimensions relatives aux épaisseurs des couches et aux largeurs des guides, elles doivent être choisies de façon à assurer un fonctionnement monomode de la structure ainsi qu'un bon couplage avec la fibre optique de sortie.

Par exemple, pour les longueurs d'ondes λ₁ = 1,3 µm et λ₂ = 1,55 µm, l'épaisseur de la couche quaternaire λ1 (GaInAsP adaptée à 1,35 µm) est de l'ordre de 0,3 µm, l'épaisseur de la couche 32 (en quaternaire adapté à 1,35 µm) est de l'ordre de 25 nm, la largeur du ruban W₁ gravé dans celle-ci de l'ordre de 3 µm, l'épaisseur de la couche 2 (en quaternaire adapté à environ 1,55 µm) de l'ordre de 0,2 µm, celle de la couche 3 (adaptée à 1,35 µm) de l'ordre de 0,15 µm.

La largeur W₂ du ruban actif gravé dans ces deux dernières couches est de l'ordre de 1 µm.

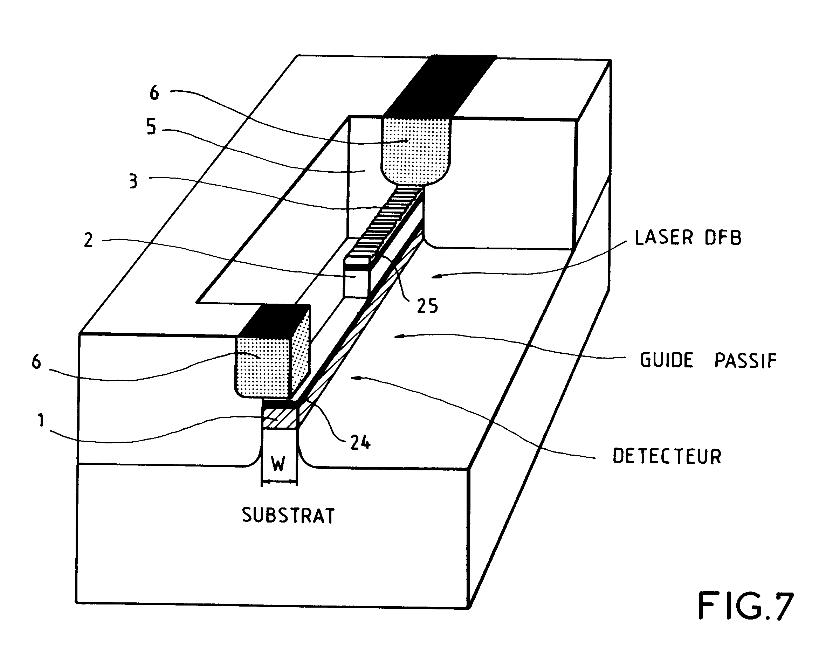

La figure 7 représente un autre exemple de procédé de réalisation selon l'invention.

Le processus technologique est le suivant :
- Première épitaxie sur un substrat d'une couche guidante 1 en matériau absorbant à λ₁ mais transparent à λ₂ (par exemple en quaternaire adapté à λ= 1,35 µm), une couche 2 active pour le laser en matériau (ou puits quantiques) adapté à λ₂ (par exemple, un quaternaire adapté à λ₂ = 1,55 µm). Cette couche peut être séparée de la couche 1 par une couche d'arrêt à la gravure chimique 24, une couche 3 en matériau transparent à λ₂ dans laquelle sera gravé le réseau de diffraction du laser DFB (par exemple un quaternaire adapté à λ = 1,3 µm). (Dans une variante de réalisation de l'invention permettant d'obtenir la version de la figure 5 (laser Perot-Fabry) cette couche n'est pas utile car elle sert uniquement à la réalisation du réseau de diffraction). La couche 3 peut être séparée de la couche 2 par une couche d'arrêt d'attaque chimique 25.
- Réalisation du réseau DFB dans la couche 3, jusqu'à la couche 25.
- Délimitation des couches 3 et 2 par gravure chimique (ou autres) sur la région constituant le laser jusqu'à la couche 10, puis gravure d'un ruban de largeur W sur toute la longueur de la structure (par exemple W = 1,5 µm).
- Reprise d'épitaxie d'un matériau 5 transparent à λ₁ et λ₂ (par exemple de l'InP), et de type semi-isolant, si possible, pour assurer une bonne isolation électrique entre détecteur et émetteur.
- Réalisation d'une hétérojonction P-N soit par diffusion localisée 6 d'un dopant (par exemple Zn), à travers un masque de diélectrique, au-dessus des zones laser et détecteur, soit par une épitaxie localisée (par exemple de l'InP de type P) après gravure de sillon dans le matériau 5.

L'ordre de grandeur des épaisseurs des couches est la même que précédemment.

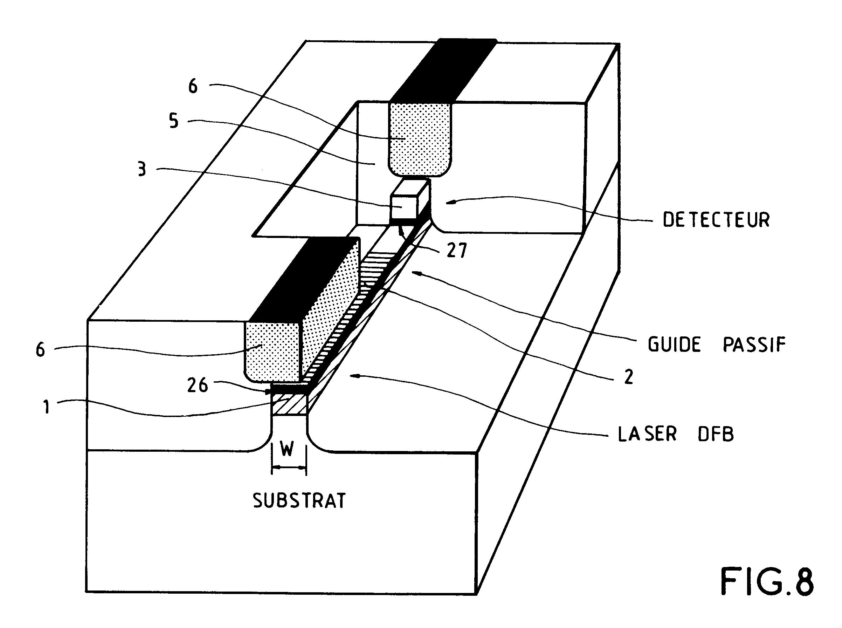

La figure 8 représente un autre procédé de réalisation.

Ce procédé concerne la réalisation d'un dispositif émettant à λ₁ et détectant à λ₂, tel que celui de la figure 4.
- Première épitaxie sur un substrat d'une couche guidante 1 en matériau adapté à λ₁ (par exemple 1,3 µm), une deuxième couche 2 en matériau transparent à λ₁ et λ₂ dans laquelle sera gravé le réseau de diffraction du DFB par exemple un quaternaire adapté à λ = 1,15 µm, une troisième couche 3 en matériau absorbant à λ₂ par exemple un quaternaire adapté à λ = 1,55 µm constituant la zone détectrice du récepteur. Ces couches peuvent être séparées entre elles par des couches d'arrêt à la gravure chimique 26 et 27.
- Après délimitation de la couche 3 par gravure chimique (ou autres) dans la région constituant le détecteur jusqu'à la couche 27, le réseau de diffraction est réalisé dans la couche 2 et uniquement dans la partie active du laser DFB en utilisant la couche d'arrêt d'attaque chimique 26.
- Gravure d'un ruban de largeur W sur toute la longueur du dispositif (par exemple W = 1,5 µm).
- Reprise d'épitaxie d'un matériau 5 transparent à λ₁ et λ₂ (par exemple InP) et si possible de type semi-isolant pour isoler électriquement l'émetteur et le détecteur.
- Réalisation d'une hétérojonction P-N soit par diffusion localisée 6 d'un dopant de type P (par exemple Zn) au-dessus des zones laser et détecteur, soit par épitaxie localisée d'une couche de type P. Le guide passif situé entre le laser et le détecteur aura une longueur suffisante pour absorber la lumière provenant du laser DFB (λ₁) de façon à éviter de saturer le détecteur ou à générer de la diaphonie (par exemple 200 µm).

La description qui précède n'a été faite qu'à titre d'exemple. D'autres variantes peuvent être envisagées sans sortir du cadre de l'invention.

Notamment, les matériaux utilisés dans les exemples précédents sont des matériaux à base de l'InP/GaInAsp, mais l'invention peut être étendue à d'autres familles de matériaux, en particulier de type III-V, tels GaAs, GaAlAs, GaInAlAs, etc ... .

De plus, les différentes structures décrites peuvent être réalisées sur des substrats de type semi-isolant permettant d'une part une meilleure isolation électrique entre détecteur et émetteur et d'autre part l'intégration d'autres fonctions optoélectroniques ou électroniques. Selon l'invention on peut également remplacer un des composants (émetteur ou détecteur) par d'autres fonctions optoélectroniques ou optiques tels que amplificateur, modulateur, etc ....).

## Revendications

1. Emetteur-récepteur optique à semiconducteurs comportant un détecteur et un laser couplés à un même guide d'onde caractérisé en ce que ce guide d'onde comporte une couche de guidage (1) recouverte d'une couche d'arrêt d'attaque chimique (21) sur laquelle est situé un élément de guidage (2), le détecteur et le laser étant situés sur l'élément de guidage et au moins une couche d'arrêt d'attaque chimique (25, 26, 21) étant située entre le laser et l'élément de guidage (2).

2. Emetteur-récepteur selon la revendication 1, caractérisé en ce que l'élément de guidage (2) a une première largeur (W1) et que le laser a une deuxième largeur (W2) différente à la première largeur.

3. Emetteur-récepteur selon la revendication 1, caractérisé en ce que l'élément de guidage (2) a une première largeur (W1) et que le laser a une deuxième largeur (W2) égale à la première largeur.

4. Emetteur-récepteur selon la revendication 1, caractérisé en ce qu'il comporte également une couche d'arrêt chimique (20)située entre le laser et l'élément du guidage (2).

5. Emetteur-récepteur selon la revendication 1, dans lequel le laser comporte un réseau de diffraction distribuée (DFB) caractérisé en ce qu'il comporte une couche d'arrêt d'attaque chimique (20) située entre le réseau de diffraction distribué et une couche active du laser.

6. Emetteur-récepteur selon la revendication 1, caractérisé en ce qu'il comporte une couche d'arrêt d'attaque chimique située entre le détecteur et l'élément de guidage (20).

7. Emetteur-récepteur optique à semiconducteurs selon la revendication 1, caractérisé en ce que le guide d'onde est gravé latéralement dans l'ensemble des couches constituant le laser le détecteur et le guide d'onde.

8. Emetteur-récepteur optique selon la revendication 7, caractérisé en ce que la structure est enterrée dans un matériau de confinement optique.

9. Procédé de réalisation d'un émetteur-récepteur à semiconducteur, caractérisé en ce qu'il comporte les étapes suivantes :
- épitaxie sur une face d'un substrat
. d'au moins une couche de guidage optique (2) ;
. de couches de matériaux (3, 6) nécessaires à la réalisation d'une part d'un laser et d'autre part d'un photodétecteur ;
. d'au moins une couche d'arrêt d'attaque chimique réalisée soit avant, soit après l'épitaxie de la couche de guidage optique (2) ;
- gravure du laser et du photodétecteur ;
- gravure dans la couche de guidage optique (2) d'un élément de guidage ;
- épitaxie d'une couche d'un matériau de confinement optique (5).

10. Procédé de réalisation d'un émetteur-récepteur à semiconducteur selon la revendication 9, caractérisé en ce qu'il comporte les étapes suivantes :
- épitaxie sur une face d'un substrat
. d'une première couche (1) de guidage optique ;
. d'une première couche (21) d'arrêt d'attaque chimique ;
. d'une deuxième couche (32) de guidage optique ;
. de couches de matériaux (3, 6) nécessaires à la réalisation d'une part d'un laser et d'autre part d'un photodétecteur ;
- gravure du laser et du photodétecteur jusqu'à la deuxième couche (32) de guidage optique ;
- gravure dans la deuxième couche (32) de guidage optique d'un élément de guidage (32) jusqu'à la première couche (21) d'arrêt d'attaque chimique ;
- épitaxie d'une couche d'un matériau de confinement (5) ;
- réalisation de jonctions PN (6) dans la couche de matériau de confinement (5).

11. Procédé selon la revendication 10, caractérisé en ce que lors de l'étape d'épitaxie sur le substrat on prévoit la réalisation d'une deuxième couche d'arrêt d'attaque chimique (20) sur la deuxième couche (32) de guidage optique, la gravure du laser et du photodétecteur se faisant alors jusqu'à cette deuxième couche d'arrêt d'attaque chimique et la gravure de l'élément de guidage (32) se faisant également dans cette deuxième couche d'arrêt d'attaque chimique.
